# EUROPÄISCHE PATENTSCHRIFT

(11) **EP 1 455 557 B1**
(45) Veröffentlichungstag und Bekanntmachung des Hinweises auf die Patenterteilung: **27.02.2013**
(21) Anmeldenummer: 03023937.0
(22) Anmeldetag: 22.10.2003
(51) Int. Cl.: H05K 1/02, H05K 1/11

(54) **Trägervorrichtung für elektrische Bauelemente**
Supporting device for electric components
Dispositif de support pour des composants électriques

(30) Priorität: 05.03.2003 DE 10309520
(43) Veröffentlichungstag der Anmeldung: 08.09.2004
(73) Patentinhaber: ROBERT BOSCH GMBH, 70442 Stuttgart (DE)
(72) Erfinder: Roozenbeck, Herman, 71701 Schwieberdingen (DE); Bayer, Uwe, 71672 Marbach (DE)

(56) Entgegenhaltungen:
- DE-A1- 19 536 848
- US-A- 5 231 308

## Beschreibung

### STAND DER TECHNIK

Die vorliegende Erfindung betrifft eine Trägervorrichtung für elektrische Bauelemente und insbesondere eine mehrschichtige Leiterplatte für den Kraftfahrzeugeinsatz.

Trägervorrichtungen für elektrische Bauelemente, wie beispielsweise Leiterplatten, weisen im allgemeinen eine Masseebene (leitfähige Ebene) auf, wodurch ein Bezugspotential bereitgestellt wird. Pulsierende Leitungsströme auf dieser Bezugsebene beeinflussen die Genauigkeit der analogen Signalverarbeitung. Aus diesem Grund ist es vorteilhaft analoge Bezugspotentialleitungen als Signalleitungen von der Masseebene getrennt zu führen. Die Bezugspotentialleitungen einer Baugruppe wären dann mit einem Masse-Bezugspunkt, auch Stempunkt genannt, verbunden, wodurch ein Bezugspotential bereitgestellt wird. Ein solcher Masse-Bezugspunkt vor allem für analoge Funktionsbaugruppen ist typischerweise in räumlicher Nähe zu einer-Auswerteeinrichtung bzw. -schaltung, wie z.B. einem Funktionsrechner, angeordnet. Externe, d.h. nicht auf der Leiterplatte angeordnete analoge Sensoren, deren Signale auf der Leiterplatte ausgewertet werden, werden wie die internen, d.h. auf der Leiterplatte befindlichen, analogen Funktionsbaugruppen von der Leiterplatte mit Masse verbunden. Sowohl Masseverbindungen bzw. Bezugspotentialleitungen dieser externen analogen Sensoren als auch Bezugspotentialleitungen der analogen Funktionsbaugruppen auf der Leiterplatte werden an denselben Masse-Stempunkt geführt, wenn die auszuwertenden Signale dieser analogen auf der Leiterplatte befindlichen Funktionsbaugruppen mit derselben Auswerteeinrichtung verarbeitet werden.

HF-Einkopplungen bzw. Einstrahlungen, beispielsweise über einen Kabelbaum in einem Kraftfahrzeug in die Bezugspotentialleitungen, werden am gemeinsamen Sternpunkt der externen analogen Sensoren und der internen Funktionsbaugruppen zur Bezugspotentialebene, welche unter der Leiterbahnebene elektrisch isoliert dazu vorgesehen ist, abgeleitet. Eine galvanische Kopplung der Bezugspotentialleitungen durch die gemeinsame Strecke der Sternpunktfläche zur Bezugspotentialebene resultiert je nach elektromagnetischer Einkopplung bzw. je nach Störpotential in einer Potentialanhebung dieses Sternpunktes, wobei davon abhängig eine Fehlauswertung der Nutzsignale in einer Auswerteeinrichtung auftritt.

Trägervorrichtungen für elektrische Bauelemente sind aus DE 195 36 848 und US 5 231 308 bekannt.

### VORTEILE DER ERFINDUNG

Die erfindungsgemäße Trägervorrichtung für elektrische Bauelemente mit den Merkmalen des Anspruchs 1 weist gegenüber dem bekannten Lösungsansatz den Vorteil auf, daß eine Potentialanhebung des Bezugspunktes der internen auf der Trägervorrichtung befindlichen Funktionsbaugruppen und damit eine Fehlauswertung der Nutzsignale der internen Funktionsbaugruppen vermieden wird.

Dadurch werden verlässliche und reproduzierbare Auswerteergebnisse bereitgestellt. HF-Störpotentiale über die Bezugspotentialleitungen analoger externer Einrichtungen, beispielsweise in einem Kabelbaum eines Kraftfahrzeugs, können somit nicht mehr auf den Masse-Sternpunkt der internen Funktionsbaugruppen bzw. -bauelementen in Form einer Potentialanhebung einwirken.

Die der vorliegenden Erfindung zugrunde liegende Idee besteht im wesentlichen darin, dass die Trägervorrichtung einen ersten Sternpunkt zum Anbinden von Bezugspotentialleitungen externer analoger Bauelemente und/oder Sensoren und einen zweiten Sternpunkt zum Anbinden von Bezugspotentialleitungen interner, d.h. auf der Trägervorrichtung befindlicher, Bauelemente aufweisen.

Mit anderen Worten wird eine Trägervorrichtung für elektrische Bauelemente bereitgestellt mit: einer ersten leitfähigen Ebene zum Bereitstellen eines Bezugspotentials; mindestens einer elektrisch von der ersten Ebene isolierten zweiten Ebene mit strukturierten Leitungen zum Anbinden elektrischer Anschlusseinrichtungen externer Bauelemente und zum Anbinden interner Bauelemente auf der Trägervorrichtung, wobei die Leitungen zum Anbinden elektrischer Anschlusseinrichtungen externer analoger Bauelemente und/oder Sensoren Bezugspotentialleitungen aufweisen, welche sich an einem ersten Sternpunkt sammeln, und die Leitungen zum Anbinden interner Bauelemente Bezugspotentialleitungen aufweisen, welche sich an einem zweiten Sternpunkt sammeln und über mindestens eine Durchkontaktierungseinrichtung mit der ersten Ebene galvanisch gekoppelt sind und/öder die Durchkontaktierungseinrichtung (23") den ersten und/oder zweiten Sternpunkt (18, 22) bildet.

Somit werden die externen analogen Bezugspotentialleitungen exklusiv mit einem Sternpunkt verbunden, wohingegen die analogen Bezugspotentialleitungen der internen analogen Bauelemente bzw. Funktionsbaugruppen ebenso exklusiv mit einem zweiten Bezugs- bzw. Sternpunkt verbunden wird.

In den Unteransprüchen finden sich vorteilhafte Weiterbildungen und Verbesserungen der im Anspruch 1 angegebenen Trägervorrichtung für elektrische Bauelemente.

Gemäß einer bevorzugten Weiterbildung ist sowohl der erste Stempunkt als auch der zweite Stempunkt über je eine Durchkontaktierungseinrichtung direkt galvanisch mit der ersten Ebene verbunden. Dies hat den Vorteil, dass beispielsweise bei einem auftretenden Kurzschluss gegebenenfalls nur eine Durchkontaktierung, d.h. ein Via von der zweiten Ebene zur ersten Ebene, welches die Bezugspotentialebene ist, beschädigt wird, wohingegen die andere Durchkontaktierung weiterhin einen Stromfluss ermöglicht.

Gemäß einer weiteren bevorzugten Weiterbildung ist der erste Sternpunkt mit dem zweiten Sternpunkt über eine Leitung in der zweiten Ebene galvanisch gekoppelt. Auf diese Weise kann vorteilhaft bereits in der zweiten Ebene ein Potentialausgleich zwischen dem ersten und dem zweiten Sternpunkt erfolgen.

Gemäß einer weiteren bevorzugten Weiterbildung ist die galvanische Kopplung der Sternpunkte zur ersten Ebene über mindestens eine Durchkontaktierung bereitgestellt, welche von der Leitung zwischen den zwei Sternpunkten ausgeht. Dies birgt den Vorteil einer unabhängigen Wahl des Durchkontaktierungspunktes unabhängig von den Sternpunkten.

Gemäß einer weiteren bevorzugten Weiterbildung ist die Trägervorrichtung eine mehrschichtige Leiterplatte. Somit wird ein vorteilhaftes Massenprodukt bereitgestellt.

Gemäß einer weiteren bevorzugten Weiterbildung weist die Trägervorrichtung eine Einrichtung zum Aufnehmen-einer Auswerteeinrichtung, vorzugsweise eines Funktionsrechners, auf. Auf diese Weise wird eine Signalverarbeitungsplatine vorteilhafter Konfiguration vorgesehen.

Gemäß einer weiteren bevorzugten Weiterbildung ist der zweite Stempunkt in räumlicher Nähe zu der Einrichtung zum Aufnehmen einer Auswerteeinrichtung angeordnet. Dies birgt den Vorteil kurzer Signalwege.

Gemäß einer weiteren bevorzugten Weiterbildung sind der erste Sternpunkt und der zweite Sternpunkt in räumlicher Nähe zueinander in der zweiten Ebene angeordnet. Durch diese Maßnahme lassen sich erforderliche Durchkontaktierungen kostengünstig auf einen kleinen Bereich der Trägervorrichtung eingrenzen.

Gemäß einer weiteren bevorzugten Weiterbildung sind über die Bezugspotentialleitungen zum Anbinden externer analoger Bauelemente und/oder Sensoren analoge Sensoreinrichtungen an ein Bezugspotential anbindbar, welche über eine Auswerteeinrichtung auf der Trägervorrichtung betreibbar sind. Dies ermöglicht eine Sensorsignalauswerteplatine vorteilhafter Gestalt.

Gemäß einer weiteren bevorzugten Weiterbildung bildet die Trägervorrichtung eine Kfz-Leiterplatte zur Verarbeitung von analogen Sensorsignalen. Dies birgt den Vorteil einer geeigneten Leiterplatte zur Verarbeitung von Sensorsignalen.

### ZEICHNUNGEN

Ein Ausführungsbeispiel der Erfindung ist in der Zeichnung dargestellt Und in der nachfolgenden Beschreibung näher erläutert.

Es zeigt:

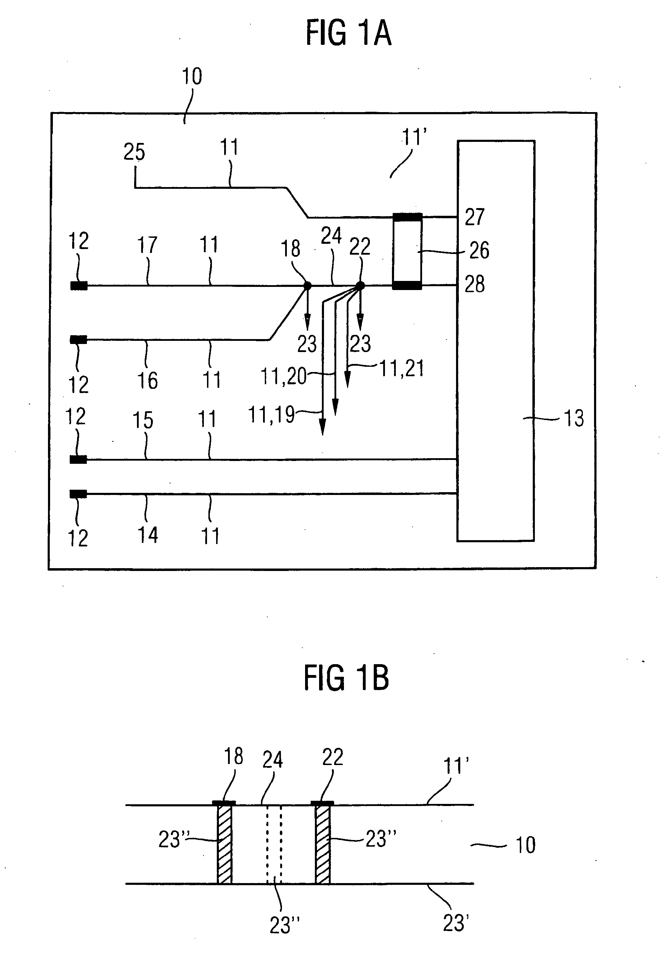

- Fig. 1 A,B: eine schematische Darstellung einer Trägervorrichtung für elektrische Bauelemente zur Erläuterung einer Ausführungsform der vorliegenden Erfindung, wobei Fig 1A eine Draufsicht und Fig. 1B eine Ausschnittsquerschnittsansicht zeigt.

### BESCHREIBUNG DES AUSFÜHRUNGSBEISPIELS

In Fig. 1A ist eine Trägervorrichtung 10, wie beispielsweise eine Leiterplatte, dargestellt. Die Trägervorrichtung 10 verfügt über eine erste Ebene 23' (in der Draufsicht gemäß Fig. 1A nicht dargestellt), welche eine Bezugspotentialebene bzw. eine elektrisch leitfähige Schicht bildet, die mit einem vorbestimmten Bezugspotential, vorzugsweise Masse, beaufschlagt wird. Darüber und elektrisch isoliert dazu ist eine zweite Ebene 11' mit strukturierten Leitungen 11 angeordnet. Über Anschlusseinrichtungen 12, beispielsweise Kontakt-Pads aufgereiht entlang einer Kante der Trägervorrichtung 10 in Form einer Messerleiste, sind externe analoge Bauelemente und/oder Sensoren, vorzugsweise Sensoreinrichtungen, an die Trägervorrichtung 10 anschließbar.

Über eine weitere Anschlusseinrichtung (nicht dargestellt) ist eine Auswerteschaltung 13, wie z.B. ein Funktionsrechner auf Halbleiterbasis, anschließbar. Ein externes Analogsignal 14 und ein weiteres externes Analogsignal 15 wird der Auswerteeinrichtung 13 über zwei Leitungen 11 und zwei Anschlusseinrichtungen 12 zugeführt. Für diese zwei externen Analogsignale 14, 15 wird ebenfalls eine Bezugspotentialleitung 16, 17 bereitgestellt. Diese Bezugspotentialleitungen 16, 17 werden in einem ersten Sternpunkt 18 zusammengeführt. Bezugspotentialleitungen 19, 20, 21, welche von internen, d.h. auf der Trägervorrichtung vorhandenen Funktionsbaugruppen bzw. Bauelementen (nicht dargestellt) herrühren, bilden einen zweiten Sternpunkt 22. Gemäß der Ausführungsform in Fig. 1A, B ist sowohl der erste Sternpunkt 18 als auch der zweite Sternpunkt 22 mittels einer Durchkontaktierungseinrichtung 23" mit der ersten Ebene 23' verbunden, welche mit einem Bezugspotential 23 verbunden ist.

Darüber hinaus besteht eine galvanische Verbindung in Form einer Leitung 24 in der Draufsicht gemäß Fig. 1A sichtbaren Ebene 11' zwischen dem ersten Sternpunkt, an welchem sich die Bezugspotentialleitungen 16, 17 der externen Bauelemente sammeln, und dem zweiten Sternpunkt 22, an welchem die Bezugspotentialleitungen 19, 20, 21 der internen auf der Trägervorrichtung 10 angeordneten Bauelemente zusammengeführt sind. Gemäß der Ausführungsform in Fig. 1A ist darüber hinaus eine Einrichtung 25 zum Bereitstellen einer Versorgungsspannung und eine Einrichtung zum Aufnehmen eines Kondensators 26 zwischen der Versorgungsspannung 25 und dem Abschnitt zwischen dem zweiten Sternpunkt 22 und der Auswerteeinrichtung 13 vorgesehen. Die Versorgungsspannung 25 wird der Auswerteeinrichtung 13 über einen Versorgungseingang 27 zugeführt, wobei die Auswerteeinrichtung 13 über eine Anschlusseinrichtung 28 mit dem Stempunkt 22 in Form einer Leitung verbunden ist.

In Fig. 1B ist eine Querschnittsansicht eines Ausschnitts der Trägervorrichtung 10 im Bereich der Sternpunkte 18, 22 dargestellt. Die erste elektrisch leitfähige Ebene 23' ist über mindestens eine Durchkontaktierungseinrichtung 23" mit den Stempunkten 18, 22 verbunden. Eine optionale Verbindungsleitung 24 zwischen den beiden Sternpunkten 18, 22 in der zweiten Ebene 11' ist vorzugsweise direkt über einer Durchkontaktierungseinrichtung 23" mit der ersten Ebene 23' elektrisch leitend in Verbindung.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Obwohl in der Ausführungsform gemäß Fig. 1A, B sowohl der erste Sternpunkt 18 als auch der zweite Sternpunkt 22 mit einer Durchkontaktierungseinrichtung 23", vorzugsweise einem Via, mit der ersten Ebene 23' (bezugspotentialbeaufschlagt) gekoppelt ist, und zwischen dem ersten und dem zweiten Sternpunkt 18, 22 eine Verbindungsleitung 24 vorhanden ist, kann die Verbindungsleitung 24 auch entfallen. Darüber hinaus, wenn die Verbindungsleitung 24 vorhanden ist, kann mindestens eine Durchkontaktierungseinrichtung 23" ausgehend von der Verbindungsleitung 24 zwischen den zwei Sternpunkten 18, 22 zur galvanischen Ankopplung der ersten Ebene 23' (Bezugspotentialebene) eingesetzt werden.

Außerdem werden die externen analogen Bezugspotentialleitungen 16, 17 entweder über eine gemeinsame Leiterbahn (nicht dargestellt) oder über mehrere getrennte Leiterbahnen gemäß Fig. 1A exklusiv mit einem Sternpunkt 18 verbunden. Die analogen Bezugspotentialleitungen 19, 20 und 21 der internen Funktionsbaugruppen bzw. -bauelemente (nicht dargestellt) werden ebenso exklusiv mit dem anderen Sternpunkt 22 verbunden. Die Sternpunkte 18, 22 sind vorzugsweise nahe beieinander und nahe der Auswerteeinrichtung 13 angeordnet.

### BEZUGSZEICHENLISTE

| | |
|---|---|
| 10 | Trägervorrichtung, z.B. Leiterplatte |
| 11 | Strukturierte Leitungen, vorzugsweise Leiterbahnen |
| 11' | Leiterbahnebene |
| 12 | Anschlusseinrichtung für externe Bauelemente |
| 13 | Auswerteeinrichtung, z.B. Funktionsrechner |
| 14 | externes Analogsignal n |
| 15 | externes Analogsignal n+1 |
| 16 | Bezugspotentialleitung externes Analogsignal n |
| 17 | Bezugspotentialleitung externes Analogsignal n+1 |
| 18 | Sternpunkt der Bezugspotentialleitung externer Analogsignale |
| 19,20,21 | Bezugspotentialleitung bei internem Analogsignal |
| 22 | Sternpunkt der Bezugspotentialleitung interner Analogsignale |
| 23 | Bezugspotential, z.B. Masse |
| 23' | Bezugspotentialebene |
| 23" | Durchkontaktierungseinrichtung zum Bezugspotential |
| 24 | Leitung (galvanische Verbindung) |
| 25 | Versorgungsspannung |
| 26 | Kondensator |
| 27 | Anschlusseinrichtung für Versorgungsspannung an Auswerteeinrichtung |
| 28 | Anschlusseinrichtung für Bezugspotential an Auswerteeinrichtung |

## Patentansprüche

1. Trägervorrichtung (10) für elektrische Bauelemente mit:
einer ersten leitfähigen Ebene (23') zum Bereitstellen eines Bezugspotentials (23); und
mindestens einer elektrisch von der ersten Ebene (23') isolierten zweiten Ebene (11') mit strukturierten Leitungen (11) zum Anbinden elektrischer Anschlusseinrichtungen (12) externer analoger Bauelemente und/oder Sensoren und zum Anbinden interner Bauelemente auf der Trägervorrichtung (10),
**dadurch gekennzeichnet,**
**daß** die Leitungen (11) zum Anbinden elektrischer Anschlusseinrichtungen (12) externer analoger Bauelemente und/oder Sensoren Bezugspotentialleitungen (16, 17) aufweisen, welche sich an einem ersten Sternpunkt (18) sammeln, und die Leitungen (11) zum Anbinden interner Bauelemente Bezugspotentialleitungen (19, 20, 21) aufweisen, welche sich an einem zweiten Sternpunkt (22) sammeln und über mindestens eine Durchkontaktierungseinrichtung (23") mit der ersten Ebene galvanisch gekoppelt sind und/oder die Durchkontaktierungseinrichtung (23") den ersten und/oder zweiten Sternpunkt (18, 22) bildet.

2. Trägervorrichtung (10) nach Anspruch 1,
**dadurch gekennzeichnet,**
**daß** sowohl der erste Sternpunkt (18) als auch der zweite Sternpunkt (22) über je eine Durchkontaktierungseinrichtung (23") direkt galvanisch mit der ersten Ebene (23') verbunden ist.

3. Trägervorrichtung (10) nach Anspruch 1,
**dadurch gekennzeichnet,**
**dass** der erste Sternpunkt (18) mit dem zweiten Sternpunkt (22) über eine Leitung (24) in der zweiten Ebene (11') galvanisch gekoppelt ist.

4. Trägervorrichtung (10) nach Anspruch 3,
**dadurch gekennzeichnet,**
**dass** die galvanische Kopplung der Sternpunkte (18, 22) zur ersten Ebene (23') über mindestens eine Durchkontaktierung (23") bereitgestellt ist, welche von der Leitung (24) zwischen den zwei Stempunkten (18, 22) ausgeht.

5. Trägervonichtung (10) nach einem der vorangehenden Ansprüche,
**dadurch gekennzeichnet,**
**dass** die Trägervorrichtung (10) eine mehrschichtige Leiterplatte ist.

6. Trägervorrichtung (10) nach einem der vorangehenden Ansprüche,
**dadurch gekennzeichnet,**
**dass** die Trägervorrichtung (10) eine Einrichtung zum Aufnehmen einer Auswerteeinrichtung (13), vorzugsweise eines Funktionsrechners, aufweist.

7. Trägervorrichtung (10) nach Anspruch 6,
**dadurch gekennzeichnet,**
**dass** der zweite Sternpunkt (22) in räumlicher Nähe zu der Einrichtung zum Aufnehmen der Auswerteeinrichtung (13) angeordnet ist.

8. Trägervorrichtung (10) nach einem der vorangehenden Ansprüche,
**dadurch gekennzeichnet,**
**dass** der erste Sternpunkt (18) und der zweite Sternpunkt (22) in räumlicher Nähe zueinander in der zweiten Ebene (11') angeordnet sind.

9. Trägervorrichtung (10) nach einem der vorangehenden Ansprüche,
**dadurch gekennzeichnet,**
**dass** über die Bezugspotentialleitungen (16, 17) zum Anbinden externer analoger Bauelemente und/oder Sensoren analoge Sensoreinrichtungen an ein Bezugspotential (23) anbindbar sind, welche über eine Auswerteeinrichtung (13) auf der Trägervorrichtung (10) auswertbar sind.

10. Trägervorrichtung (10) nach einem der vorangehenden Ansprüche,
**dadurch gekennzeichnet,**
**dass** die Trägervorrichtung (10) eine Kfz-Leiterplatte zur Verarbeitung von analogen Sensorsignalen bildet.

## Claims

1. Support apparatus (10) for electrical components, having:
a first conductive level (23') for providing a reference potential (23); and
at least one second level (11') which is electrically insulated from the first level (23') and has patterned lines (11) for the connection of electrical connection devices (12) of external analogue components and/or sensors and for the connection of internal components on the support apparatus (10),
**characterized**
**in that** the lines (11) for the connection of electrical connection devices (12) of external analogue components and/or sensors have reference potential lines (16, 17) which combine at a first star point (18), and the lines (11) for the connection of internal components have reference potential lines (19, 20, 21) which combine at a second star point (22), and the said lines are electrically conductively coupled to the first level by means of at least one through-plating device (23") and/or the through-plating device (23") forms the first and/or second star point (18, 22).

2. Support apparatus (10) according to Claim 1,
**characterized**
**in that** both the first star point (18) and the second star point (22) are directly electrically conductively connected to the first level (23') by means of a through-plating device (23") in each case.

3. Support apparatus (10) according to Claim 1,
**characterized**
**in that** the first star point (18) is electrically conductively coupled to the second star point (22) by means of a line (24) in the second level (11').

4. Support apparatus (10) according to Claim 3,
**characterized**
**in that** the electrically conductive coupling between the star points (18, 22) and the first level (23') is provided by means of at least one through-plating (23") which starts from the line (24) between the two star points (18, 22).

5. Support apparatus (10) according to one of the preceding claims,
**characterized**
**in that** the support device (10) is a multilayered printed circuit board.

6. Support apparatus (10) according to one of the preceding claims,
**characterized**
**in that** the support apparatus (10) has a device for accommodating an evaluation device (13), preferably a functional computer.

7. Support apparatus (10) according to Claim 6,
**characterized**
**in that** the second star point (22) is arranged in the physical vicinity of the device for accommodating the evaluation device (13).

8. Support apparatus (10) according to one of the preceding claims,
**characterized**
**in that** the first star point (18) and the second star point (22) are arranged in the physical vicinity of one another in the second level (11').

9. Support apparatus (10) according to one of the preceding claims,
**characterized**
**in that** analogue sensor devices can be connected to a reference potential (23) by means of the reference potential lines (16, 17) for the connection of external analogue components and/or sensors, it being possible to evaluate the said analogue sensor devices by means of an evaluation device (13) on the support apparatus (10).

10. Support apparatus (10) according to one of the preceding claims,
**characterized**
**in that** the support apparatus (10) forms a motor vehicle printed circuit board for processing analogue sensor signals.

## Revendications

1. Dispositif de support (10) pour des composants électriques avec :
un premier plan conducteur (23') servant à mettre à disposition un potentiel de référence (23) ; et
au moins un deuxième plan (11') isolé sur le plan électrique par rapport au premier plan (23') et pourvu de câbles structurés (11) permettant de raccorder des dispositifs de raccordement électrique (12) de composants et/ou de capteurs externes analogiques et de raccorder des composants internes placés sur le dispositif de support (10) ;
**caractérisé en ce que** :
les câbles (11) servant à raccorder les dispositifs de raccordement électrique (12) des composants et/ou des capteurs analogiques externes présentent des câbles de potentiel de référence (16, 17) rassemblés au niveau d'un premier point neutre (18) et les câbles (11) servant à raccorder les composants internes comportant des câbles de potentiel de référence (19, 20, 21) rassemblés au niveau d'un deuxième point neutre (22) et sont couplés sur le plan galvanique au premier plan par le biais d'au moins un dispositif de mise en contact traversant (23") et/ou que le dispositif de mise en contact traversant (23") forme le premier et/ou le deuxième point neutre (18, 22).

2. Dispositif de support (10) selon la revendication 1, **caractérisé en ce que** tant le premier point neutre (18) que le deuxième point neutre (22) sont directement reliés sur le plan galvanique au premier plan (23') par le biais d'un dispositif de mise en contact traversant (23") respectif.

3. Dispositif de support (10) selon la revendication 1, **caractérisé en ce que** le premier point neutre (18) est couplé sur le plan galvanique au deuxième point neutre (22) par le biais d'un câble (24) placé dans le deuxième plan (11').

4. Dispositif de support (10) selon la revendication 3, **caractérisé en ce que** le couplage galvanique des points neutres (18, 22) est mis à disposition par rapport au premier plan (23') par le biais d'au moins un élément de mise en contact traversant (23") partant du câble (24) prévu entre les deux points neutres (18, 22).

5. Dispositif de support (10) selon l'une quelconque des revendications précédentes, **caractérisé en ce que** le dispositif de support (10) est une plaque conductrice à plusieurs couches.

6. Dispositif de support (10) selon l'une quelconque des revendications précédentes, **caractérisé en ce que** le dispositif de support (10) comporte un dispositif conçu pour recevoir un dispositif d'analyse (13), de préférence un calculateur de fonctions.

7. Dispositif de support (10) selon la revendication 6, **caractérisé en ce que** le deuxième point neutre (22) est disposé à proximité spatiale du dispositif de logement du dispositif d'analyse (13).

8. Dispositif de support (10) selon l'une quelconque des revendications précédentes, **caractérisé en ce que** le premier point neutre (18) et le deuxième point neutre (22) sont disposés à proximité spatiale l'un de l'autre dans le deuxième plan (11').

9. Dispositif de support (10) selon l'une quelconque des revendications précédentes, **caractérisé en ce que** des dispositifs analogiques de détection peuvent être raccordés à un potentiel de référence (23) par le biais des câbles de potentiel de référence (16, 17) servant à raccorder les composants et/ou les capteurs analogiques externes et peuvent être analysés par le biais d'un dispositif d'analyse (13) placé sur le dispositif de support (10).

10. Dispositif de support (10) selon l'une quelconque des revendications précédentes, **caractérisé en ce que** le dispositif de support (10) forme une plaque conductrice de véhicule automobile servant au traitement de signaux de capteurs analogiques.
